## Europäisches Patentamt
## European Patent Office
## Office européen des brevets

(11) Numéro de publication: **0 047 690**
**B1**

(12) # FASCICULE DE BREVET EUROPEEN

(45) Date de publication du fascicule du brevet:
04.04.84

(51) Int. Cl.³: **H 01 L 23/56,** H 03 F 1/18,
H 01 P 5/12

(21) Numéro de dépôt: **81401336.3**

(22) Date de dépôt: **25.08.81**

(54) **Amplificateur monolithique comportant un système de division et de recombinaison de puissance groupant plusieurs transistors.**

(30) Priorité: **02.09.80 FR 8018926**

(43) Date de publication de la demande:
**17.03.82 Bulletin 82/11**

(45) Mention de la délivrance du brevet:
**04.04.84 Bulletin 84/14**

(84) Etats contractants désignés:
**DE GB NL**

(56) Documents cités:
**GB - A - 1 235 472**
**US - A - 3 967 218**
**US - A - 3 969 745**
**US - A - 4 023 198**

**JAPANESE JOURNAL OF APPLIED PHYSICS-SUPP.,**
**vol. 15, no. 7, 1976, TOKYO (JP) M. FUKUTA et al.:**
**"Invited: GaAs X-Band Power FET", pages 151-156**
**MICROWAVE JOURNAL, vol. 23, no. 3, mars 1980,**
**Horizon House, DEDHAM (US) R.A. PUCEL: "Power**
**Combiner Performance of GaAs MESFET", pages 51-56**

(73) Titulaire: **THOMSON-CSF, 173, Boulevard Haussmann,**
**F-75379 Paris Cedex 08 (FR)**

(72) Inventeur: **Bert, Alain, THOMSON-CSF-SCPI 173, bld**
**Haussmann, F-75360 Paris Cedex 08 (FR)**
Inventeur: **Kaminsky, Didier,**
**THOMSON-CSF-SCPI 173, bld Haussmann,**
**F-75360 Paris Cedex 08 (FR)**

(74) Mandataire: **Taboureau, James et al, THOMSON-CSF**
**SCPI 173, Bld Haussmann, F-75379 Paris Cedex 08 (FR)**

Il est rappelé que: Dans un délai de neuf mois à compter de la date de publication de la mention de la délivrance du brevet européen toute personne peut faire opposition au brevet européen délivré, auprès de l'Office européen des brevets. L'opposition doit être formée par écrit et motivée. Elle n'est réputée formée qu'après paiement de la taxe d'opposition (Art. 99(1) Convention sur le brevet européen).

BUNDESDRUCKEREI BERLIN

# Amplificateur monolithique comportant un système de division et de récombinaison de puissance groupant plusieurs transistors

L'invention concerne une nouvelle façon de combiner un certain nombre d'amplificateurs élémentaires, constitués notamment par des transistors à effet de champ réalisés sur une mêmes plaquette semiconductrice, en vue d'obtenir un amplificateur monolithique ayant une puissance élevée sur une large bande passante, l'ensemble des moyens utilisés étant intégré sur la même plaquette semiconductrice.

La puissance d'un transistor à effet de champ est directement proportionelle à la largeur de la grille, toutes choses égales par ailleurs. La seule solution largement repandue à l'heure actuelle, pour obtenir une puissance notable sans introduire de pertes susceptibles de dégrader le gain, consiste à mettre en parallèle un certain nombre de transistors identiques dont la largeur est typiquement de 100 à 200 m. Les puissances que l'on sait obtenir sont de l'ordre de 0,5 W par mm de grille (1 W/mm en laboratoire), en bande X. Le nombre d'éléments à mettre en parallèle est donc de l'ordre de 10 à 20 par watt; la dimension longitudinale de chaque transistor dépend de la façon dont la source est reliée à la masse; elle vaut typiquement 50 à 150 µm pour des transistors, en bande X et Ku. Par mise en parallèle on obtient donc une dimension longitudinale de l'ordre de 0,5 à 1 mm/W en moyenne.

Or toutes les connexions métalliques réalisées pour effectuer la liaison entre ces éléments (grilles et drains) constituent avec l'embase métallique sur laquelle est soudé l'amplificateur, une ligne de propagation dont la longueur d'onde est d'environ 10 mm à 10 GHz (sur arséniure de gallium). A partir de quelques watts de puissance, il apparait ainsi que les dimensions des connexions deviennent de l'ordre de grandeur du quart de longueur d'onde. L'uniformité de la distribution de puissance entre les différents éléments devient dès lors impossible: les performances ne peuvent plus être proportionnelles au nombre d'éléments. C'est une raison pour laquelle on réalise des amplificateurs sous forme de »modules« dont la puissance ne dépasse généralement pas 1 watt en bande X.

La réalisation d'amplificateurs de plusieurs watts exige la mise en parallèle de plusieurs modules. On sait effectuer cette mise en parallèle en utilisant des diviseurs-recombineurs réalisés sur des supports distincts de ceux des modules. Outre les difficultés technologiques, cette méthode ne donne pas de bons résultats si les modules ne sont pas rigouresement identiques et placés sur des trajets de longueurs rigoureusement égales.

On connaît une solution partielle à ces difficultés en utilisant un diviseur en phase dit de Wilkinson, comportant des résistances d'équilibrage. Une disposition en étoile comportant une répartition sur un cylindre des transistors et de leurs éléments d'adaptation permet d'obtenir une grande puissance mais présente le double inconvénient d'une bande d'amplification de largeur très faible et d'une réalisation très complexe.

L'utilisation de coupleurs dits de Lange permet d'obtenir une cascade pyramidale de coupleurs (par deux), grâce à laquelle on obtient une large bande de fréquence. Mais on ne peut associer un grand nombre d'amplificateurs élémentaires qu'au prix d'une complexité notable.

Dans la demande de brevet europien EP-A-0 032 332 au nom de la demanderesse, on décrit un répartiteur de puissance haute fréquence utilisant un diviseur à onde progressive. Dans un amplificateur doté d'un tel système la puissance est répartie progressivement sur différents modules amplificateurs au fur et à mesure de la propagation le long d'un diviseur d'entrée. La remise en phase s'effectue en utilisant une structure du même type pour la recombinaison des puissances en sortie. Des résistances déposées sur les plaquettes semiconductrices des modules permettent à la fois l'équilibrage entre les voies et l'absorption des ondes réfléchies dues aux désadaptations des modules.

L'invention permet de s'affranchir des résistances d'équilibrage ce qui est une simplification dans le cas d'amplificateurs monolithiques à très grand nombre de transistors, en n'utilisant qu'une seule charge d'absorption des ondes réfléchies et cela tout en réalisant l'ensemble de l'amplificateur sur une seule plaquette semiconductrice.

L'invention consiste en un amplificateur hyperfréquence monolithique, comportant un système de division et de recombinaison de la puissance de plusieurs transistors groupés en ligne sur un substrat semi-isolant, caractérisé en ce qu'il comporte:

— une ligne d'entrée de type microbande, formée par une ligne de transmission des signaux d'entrée, formant un angle d'incidence avec la ligne des transistors, et par une ligne d'absorption des ondes réfléchies formant avec la ligne des transistors un angle de réflexion égal à l'angle d'incidence, et se terminant sur une charge résistive d'absorption, mise à la masse,

— une ligne de transmission des signaux de sortie, de type microbande, parallèle à la ligne de transmission des signaux d'entrée

— une première pluralité de lignes de transformation d'impédance, raccordées chacune, d'une part à la ligne de transmission des signaux d'entrée et d'autre part à une électrode d'entrée d'un transistor, chaque ligne de transformation d'impédance étant constituée par deux dépôts métalliques rectangulaires reliés par une étroite bande métallique, les deux dépôts métalliques, formant capacités avec le substrat et le plan de masse, étant calculés en fonction du rapport de transformation d'impédance à réaliser, le raccordement des lignes de transformation d'impédance à la ligne de transmission des signaux d'entrée, par les dépôts métalliques, laissant subsister des fentes entre les dépôts métalliques

— une seconde pluralité de lignes de transformation d'impédance, constituées, dans leurs composants, de la même façon que la première pluralité de lignes, mais raccordées à l'électrode de sortie d'un transistor et à la ligne de transmission des signaux de sortie, à laquelle elles sont raccordées, par les dépôts métalliques, en laissant subsister des fentes entre dépôts métalliques

— cet amplificateur hyperfréquence comportant en outre des fentes dans les lignes microbandes d'entrée, de réflexion et de sortie, respectivement, selon leur axe longitudinal.

L'invention sera mieux comprise, et d'autres caractéristiques apparaitront, au moyen de la description qui suit, et des dessins qui l'accompagnent, parmi lesquels:

— la fig. 1 représente schématiquement une réalisation de l'invention;

— les fig. 2, 3 et 4 représentent schématiquement des variantes de cette réalisation.

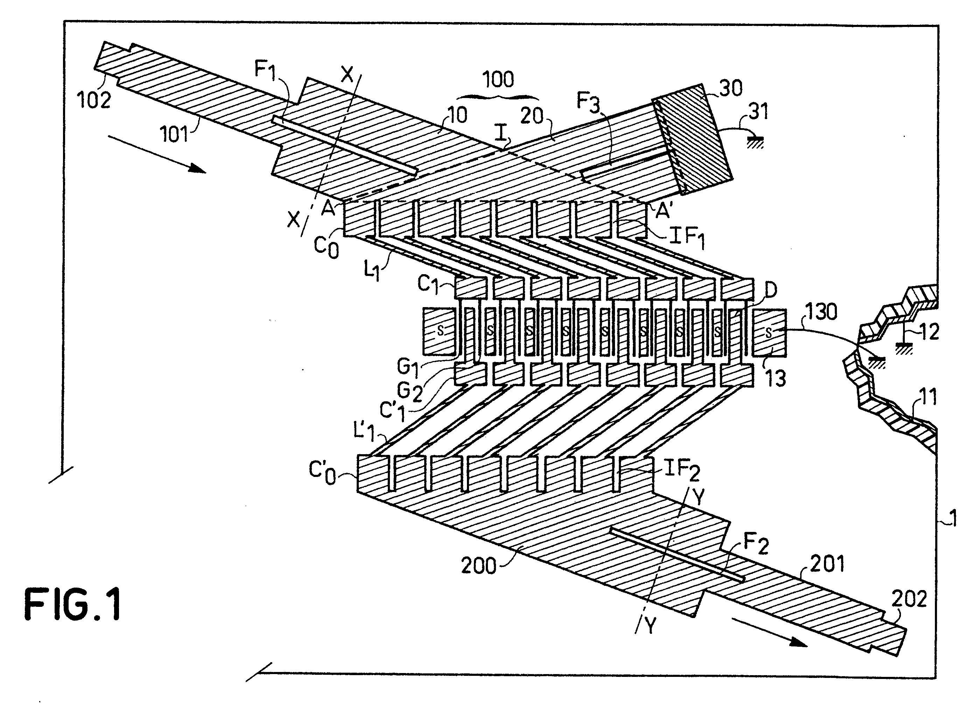

Sur la fig. 1, on a représenté une plaquette semiconductrice 1, constituée par un substrat monocristallin d'arséniure de gallium, dopé de façon à être semi-isolant, recouvert, à sa partie inférieure d'une métallisation 11 jouant le rôle de plan de masse, et destiné à recevoir à la partie opposée des contacts de transistors et des métallisations de lignes de transmission du type microbande.

Le dessin de la plaquette comporte une échancrure faisant apparaitre l'épaisseur du substrat 1 et de son plan de masse 11, que l'on a relié schématiquement à la masse par une connexion symbolique 12.

On a limité à 8 le nombre de transistors représentés et à deux le nombre de leurs grilles (l'électrode de chaque grille est symbolisée par un trait d'une certaine épaisseur). Les sources et les drains de ces transistors à effet de champ sont des contacts ohmiques réalisés de façon classique par couches métalliques successives. Les grilles sont des métallisations réalisées de façon classique pour donner un contact Schottky.

Toutefois on observe les particularités suivantes:

a) les sources, marquées S sur la figure 1, sont reliées au plan de masse soit par un trou métallisé pratiqué dans l'arséniure de gallium (donc invisible sur la figure), soit par fil d'or 130 comme on l'a représenté pour l'électrode 13. On a réalisé neuf contacts de source pour huit transistors, car de façon classique chaque paire de grilles $G_1$ et $G_2$ est flanquée de deux constacts S, tandis qu'en tre les grilles elles-mêmes on trouve un contact de drain D.

b) chaque paire de grilles, constituant l'entrée d'un amplificateur élémentaire, est reliée à des métallisations constituant autant de lignes de transformation d'impédance. Chaque ligne comporte deux dépôts métalliques rectangulaires $C_1$ et $C_0$ reliés par une étroite bande métallique $L_1$. Le schéma équivalent en haute fréquence d'une telle ligne est un filtre passe-bas comportant une partie inductive ($L_1$) et deux capacités ($C_0$ et $C_1$) de valeurs calculées en fonction du rapport de transformation d'impédance à réaliser, compte-tenu du fait que la capacité propre de chaque dépôt est modifiée par les capacités des éléments auxquels il est raccordé, à savoir celles des grilles du transistor à effet de champ pour $C_1$ et la capacité, au point de raccordement, d'une ligne de transmission 100 de type microbande à deux branches 10 et 20 se raccordant entre elles suivant un triangle AIA'.

c) chaque drain est relié à une des métallisations constituées par des lignes de transmission analogues disposées du côté de la sortie de chaque amplificateur élémentaire. On trouve donc une bande métallique étroite $L'_1$ reliant deux dépôts $C'_1$ et $C_0$. Le filtre passebas est différent de celui du côté grille en raison de la différence d'impédance.

Concernant les lignes de transformation d'impédance elles-même, on remarque:

1°) Que les dépôts métalliques $C_0$ et $C'_0$ se raccordent aux lignes 100 et 200, respectivement, en laissant subsister des fentes $IF_1$ et $IF_2$ entre ces dépôts.

2°) Que l'inclinaison des bandes $L_1$ et $L'_1$ par rapport à la rangée de transistors est facultative et n'a d'autre but que d'économiser la surface occupée par l'amplificateur sur la plaquette d'arséniure de gallium, matériau onéreux. Un gain d'encombrement de l'ensemble est également recherché.

Quant à l'inclinaison des lignes 100 et 200, par ailleurs parallèles entre elles, elle est guidée par les considérations suivantes:

a) on veut faciliter la division de l'impédance caractéristique de chaque ligne en la répartissant entre les dépôts $C_0$ et $C'_0$ situés respectivement à l'entrée de chaque ligne de transformation d'impédance.

b) on veut faciliter le raccordement en biais par le côté IA' du triangle AIA', de la branche 20 de la ligne 100.

c) en ce qui concerne la ligne 200, son parallélisme avec la ligne 100 permet de corriger les déphasages entrainés par le raccordement en biais de la ligne 100 à la rangée de transistors.

Enfin la branche 20 de la ligne 100 aboutit à une charge résistive 30 constituée par exemple par un dépôt d'alliage au nickel et au chrome. Cette charge 30 est à la masse, ce qui est symbolisé par une connexion 31, mais réalisé le plus souvent par un raccordement à travers l'épaisseur de la plaquette 1.

D'autres caractéristiques sont repésentées figure 1, concernant les lignes 100 et 200:

D'une part ces lignes comportent des tronçons de largeur décroissantes 101 et 102, 201 et 202. Le tronçon de plus petite largeur correspond par exemple à l'impédance normale des équipements en haute fréquence, soit 50 ohms. Les tronçons plus larges sont des impédances plus faibles dont on tient compte dans le calcul des lignes de transformation d'impédance à l'entrée comme à la sortie de chaque transistor.

D'autre part de fentes $F_1$ pour la ligne 10, $F_3$ pour la ligne 20, $F_2$ pour la ligne 200, sont pratiquées dans l'axe longitudinal de chaque ligne. Ces fentes sont éventuellement remplies par un dépôt résistif. Elles visent à supprimer tout mode de propagation de l'onde progressive dans le sens transverse, c'est à dire celui des axes XX et YY perpendiculaires à la direction de l'axe longitudinal de la ligne.

Le fonctionnement de l'amplificateur ainsi décrit peut se résumer comme suit.

Si l'on fait d'abord abstraction de la branche 20, en supposant la branche 10 délimitée par la ligne IA', on trouve en première approximation l'association en parallèle de huit lignes d'impédance caractéristique huit fois plus élevée que la branche 10 (dans sa partie la plus large). Ainsi en supposant que cette dernière est de 12,5 ohms, chacune des huit lignes fictives correspond à une impédance de 100 ohms. Dès lors, en supposant en outre que les lignes de transformation d'impédance ramènent chacune une impédance de 100 ohms la ligne la plus large de la branche 10 est parfaitement adaptée. Ceci n'est vérifié que pour les fréquences les plus hautes de la bande dans laquelle on désire faire fonctionner l'amplificateur.

On remarque en outre que les différents transistors ne sont pas en phase. Mais la disposition de l'amplificateur est telle que ce retard est composé en sortie, comme il a déjà été dit. Telle quelle, cette disposition permet d'attaquer une rangée de transistors telle que la longueur AA' soit éventuellement supérieure au quart de longueur d'onde (dans le substrat), en partant d'une ligne de transmission de largeur plus petite, dont la valeur est choisie en fonction de l'impédance ramenée par les lignes de transformation d'impédance ($C_0$, $L_1$, $C_1$).

Si l'on considère maintenant les fréquences les plus basses d'une bande de fréquence relativement large, les amplificateurs élémentaires constitués par les différents transistors ne présentent plus l'impédance désirée de 100 ohms, dans l'exemple choisi. Il apparait une partie réactive, généralement capacitive. En conséquence, des ondes réfléchies apparaissent avec des phases différentes de chaque entrée d'amplificateur élémentaire. Or, l'ensemble des branches 10 et 20 peut être grossièrement assimilé à une ligne coudée dont le coude a été tronqué. On sait qu'on peut dans ce cas, choisir convenablement la distance entre le point I et la ligne AA' de façon telle que toute l'énergie incidente dans la branche 10 se retrouve dans la branche 20. Cela tient à des relations de phase qui font que les ondes élémentaires réfléchies se retrouvent en phase dans la branche 20, ce qui n'est pas le cas pour la branche 10. Ce résulat est admissible pour les longueurs de AA' de l'ordre du quart de longueur d'onde, car les ondes réfléchies dans la branche 10 se trouvent alors en opposition de phase aux deux extrémités de cette ligne.

Tout ce qui précède suppose qu'il n'existe pas de propagation suivant le mode antisymétrique, ce qui est pallié part les fentes $F_1$ et $F_3$ déjà décrites. Dans ces donditions, les réflexions sont donc absorbées soit dans la résistance 30, soit dans la fente $F_3$ quand celle-ci résistive. On peut ainsi réaliser l'égalisation du gain d'amplification dans une large bande passante, malgré les réfléxions sélectives à l'entrée des amplificateurs élémentaires.

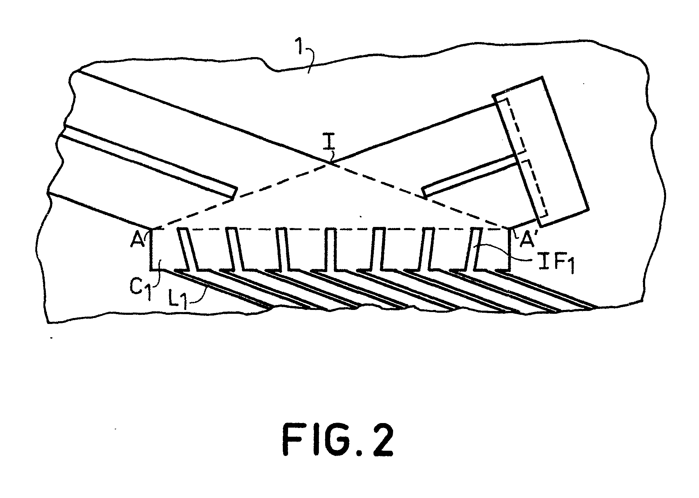

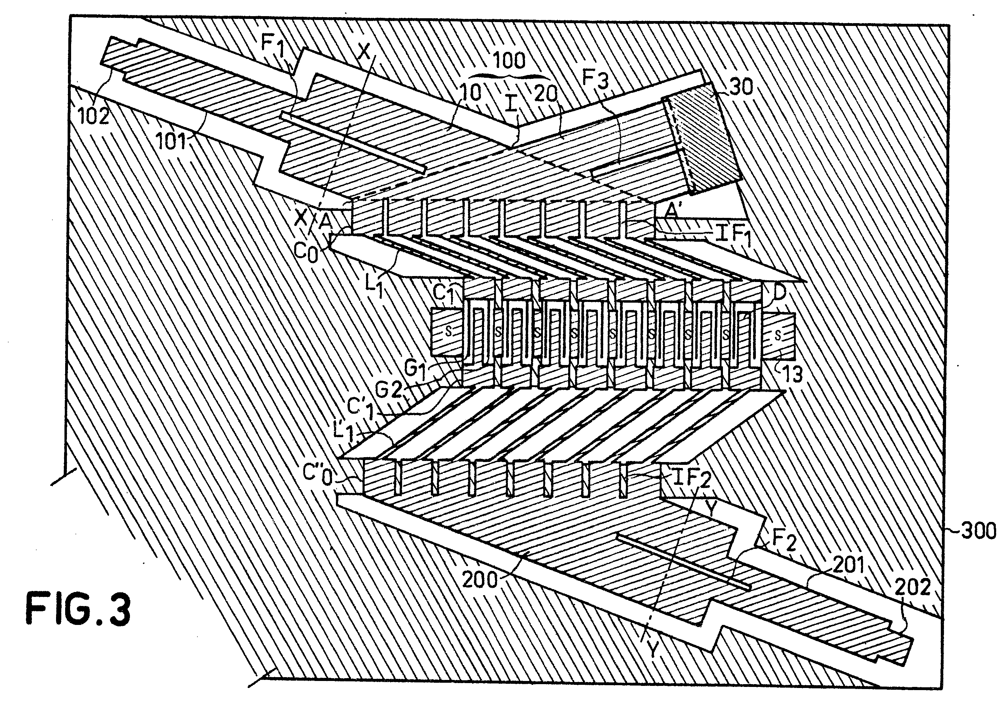

Des variantes de l'amplificateur repésenté à la figure 1 sont représentées sur les figures 2 et 3.

Sur la figure 2, on n'a représenté que la partie de l'amplificateur entourant le triangle AIA'. Dans cette variante, la fente $IF_1$ de chaque extrémité de la rangée de sept fentes est inclinée vers l'extérieur, afin de réduire l'accès au dépôt $C_1$ du courant venant de la branche 10. La fente médiane demeure telle quelle tandis que les fentes intermédiaires sont progressivement inclinées. Le résultat recherché est l'égalisation des courants à l'entrée des lignes conduisant aux différents transistors. En raison de la répartition inégale du courant de très haute fréquence, selon laquelle la densité de courant est beaucoup plus forte sur les bords de la ligne de transmission, les accès des dépôts $C_0$ situés dans des positions de plus en plus excentriques doivent être progressivement réduits, pour compenser le surcroit de densité de courant aux extrémités.

Sur la figure 3, on a représenté l'ensemble d'un amplificateur analogue à celui de la figure 1, sauf sur les points suivants:

— la plaquette 1 ne comporte plus nécessairement de métallisation inférieure;
— une métallisation 300 a été effectuée, avant dèpôt des métallisations des lignes de transformation d'impédance, sur le pourtour de la plaquette, mais assez près des lignes de transmission pour constituer un plan de masse du type de celui d'une ligne coplanaire.

En outre les contacts ohmiques S sont reliés entre eux et reliés à la masse par le fait que la métallisation 300 est déposée à l'emplacement même des dèpôts $C_1$, $C'_1$ ainsi que $C_0$ et $C'_0$. Bien que les contacts S soient dessinés sur la figure 3 (pour la clarté de la représentation), ils ne se distinguent pas à l'examen du produit fini.

Les capacités correspondantes des lignes de transformation d'impédance sont réalisées en déposant une couche d'oxyde (par exemple $SiO_2$) aux emplacements correspondants, puis en déposant une métallisation supplémentaire qui joue le rôle de la deuxième armature dont la métallisation 300 est la première armature.

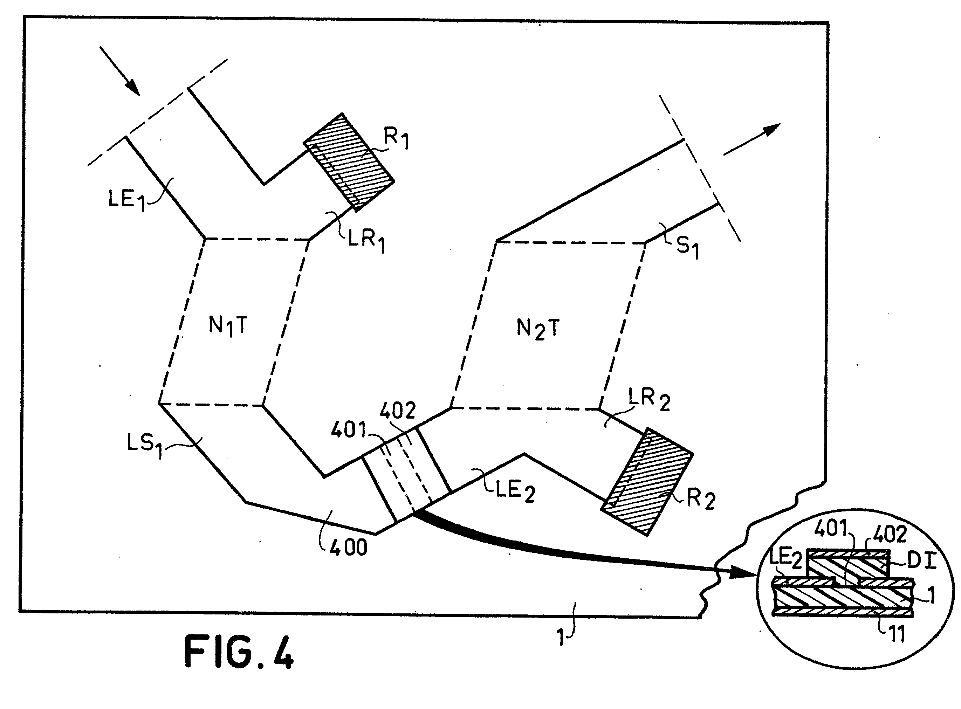

Sur la figure 4, on a représenté, de façon très simplifiée, un amplificateur monolithique à deux étages, comprenant deux amplificateurs analogues à celui de la figure 1, réalisés sur la même plaquette 1 d'arséniure de gallium. Ils comportent respectivement une rangée $N_1T$ de $n_1$ transistors et une rangée $N_2T$ de $n_2$ transistors. La ligne de sortie $LS_1$ du premier amplificateur est raccordée à la ligne de transmission d'entrée $LE_2$ du second, en ménageant un découplage capacitif afin de pouvoir polariser séparément les drains du premier et les grilles du second amplificateur.

Afin de réduire la surface de la plaquette, les deux amplificateurs sont diposés sensiblement »tête-bêche«, ce qui nécessite un raccordement des lignes $LS_1$ et $LE_2$ par une partie coudée 400. Le dessin de cette partie coudée est déterminé d'une manière analogue à celle de la partie coudée de la ligne $LE_1$.

Le premier amplificateur comporte une ligne d'entrée $LE_1$ qui correspond à la branche 10 de la ligne 100 (figure 1) et une ligne de dérivation $LR_1$ terminée par une charge résistive $R_1$, ligne et charge analogues respectivement à la branche 20 et à la charge 30 de l'amplificateur de la figure 1.

Le découplage capacitif des lignes $LS_1$ et $LE_2$ est effectué par exemple en interrompant la ligne $LE_2$ en un point 401, en déposant une couche d'oxyde isolant DI, par exemple en silice $SiO_2$, par dessus l'intervalle 401, et en recouvrant la couche d'oxyde par un dèpôt métallique 402.

Le deuxième amplificateur comporte en outre une ligne de dérivation $LR_2$ terminée par une résistance $R_2$ analogue à la charge résistive $R_1$.

Enfin une ligne de sortie $LS_2$, située à la sortie du deuxième amplificateur constitue la sortie de l'amplificateur à deux étages.

Parmi les avantages non déjà mentionnés de l'invention on citera la possibilité d'obtenir sur une plaquette d'arséniure de gallium de 20 à 40 mm² une puissance de 1 à quelques watts à la fréquence de 10 GHz avec une bande de fréquence supérieure à 50% et un gain d'amplification de plusieurs décibels.

L'invention est applicable à un amplificateur comportant des transistors bipolaires, en remplaçant respectivement la source, la grille et le drain du transistor à effet de champ par l'émetteur, la base et les collecteur du transistor bipolaire.

## Revendications

1. Amplificateur hyperfréquence monolithique, comportant un système de division et de recombinaison de la puissance de plusieurs transistors groupés en ligne sur un substrat (1) semi-isolant, caractérisé en ce qu'il comporte:

— une ligne d'entrée (100) de type microbande, formée par une ligne de transmission (10) des signaux d'entrée, formant un angle d'incidence avec la ligne des transistors, et par une ligne d'absorption des ondes réfléchies (20) formant avec la ligne des transistors un angle de réflexion égal à l'angle d'incidence et se terminant sur une charge résistive d'absorption (30), mise à la masse (31),

— une ligne de transmission (200) des signaux de sortie, de type microbande, parallèle à la ligne de transmission (10) des signaux d'entrée,

— une première pluralité de lignes de transformation d'impédance, raccordées, chacune d'une part à la ligne de transmission (10) des signaux d'entrée et d'autre part à une électrode d'entrée d'un transistor, chaque ligne de transformation d'impédance étant constituée par deux dépôts métalliques, rectangulaires ($C_0$, $C_1$) reliés par une étroite bande métallique ($L_1$), les deux dépôts métalliques ($C_0$, $C_1$), formant capacités avec le substrat (1) et le plan de masse (11), étant calculés en fonction du rapport de transformation d'impédance à réaliser, le raccordement les lignes de transformation d'impédance à la ligne de transmission (10) des signaux d'entrée, par les dépôts métalliques ($C_0$), laissant subsister des fentes ($IF_1$) entre les dépôts métalliques ($C_0$)

— une seconde pluralité de lignes de transformation d'impédance, constituées, dans leurs composants ($C'_0$, $L'_1$, $C'_1$), de même façon que la première pluralité de lignes, mais raccordées à l'électrode de sortie d'un transistor et à la ligne de transmission (200) des signaux de sortie, à laquelle elles sont raccordées, par les dépôts métalliques ($C'_0$), en laissant subsister des fentes ($IF_2$) entre dépôts métalliques,

— cet amplificateur hyperfréquence comportant en outre des fentes ($F_1$, $F_2$, $F_3$) dans les lignes microbandes d'entrée (10) de réflexion (20) et de sortie (200), respectivement, selon leur axe longitudinal.

2. Amplificateur selon la revendication 1, caractérisé en ce que les lignes de transmission (100, 200) étant du tyope microbande, le conducteur de chaque ligne est gravé sur une première grande face de la plaquette de substrat (1), et le plan de masse (11) est réalisé par une métallisation de la deuxième grande face de la plaquette, opposée à la première.

3. Amplificateur selon la revendication 1, caractérisé en ce que les lignes de transmission (100, 200) sont du type coplanaire, le conducteur central de chaque ligne étant entouré de métallisations reliées entre elles pour constituer un plan de masse unique (300) gravé sur la même grande face de la plaquette que le conducteur central.

4. Amplificateur selon la revendication 1, caractérisé en ce qu'il comporte des transistors à effet de champ dont les sources sont reliées au plan de masse (11), les grilles à la première ligne de transmission (10) et les drains à la deuxième ligne de transmission (200).

5. Amplificateur selon la revendication 1, caractérisé en ce qu'il comporte des transistors bipolaires dont les émetteurs sont reliés au plan de masse (11), les bases à la première ligne de transmission (10) et le collecteur à la deuxième ligne de transmission (200).

6. Amplificateur selon la revendication 3, caractérisé en ce que, les lignes de transmission (10, 200) étant du type coplanaire et les transistors du type à effet de champ, les sources sont raccordées à la métallisation du plan de masse (300), cette métallisation passant sous une partie des lignes de transformation d'impédance grâce à l'interposition d'un dèpôt isolant entre le plan de masse et ces dernières.

7. Dispositif d'amplification comportant au moins un premier et un second amplificateur, caractérisé en ce que les deux amplificateurs sont réalisés sur la même plaquette et polarisés séparément.

8. Dispositif selon la revendication 9, caractérisé en ce que la deuxième ligne de transmission (L51) du premier amplificateur et la première ligne de transmission (LE2) du second amplificateur sont raccordés par une partie coudée et comportant un découplage capacitif (401, 402).

**Patentansprüche**

1. Monolithischer Höchstfrequenzverstärker mit einem System zur Teilung und Rekombination der Leistung mehrerer Transistoren, die zeilenförmig auf einem halbisolierenden Substrat (1) gruppiert sind, dadurch gekennzeichnet, da er umfaßt:

— eine Eingangsleitung (100) vom Typ einer miniaturisierten Streifenleitung, die aus einer Übertragungsleitung (10) für die Eingangssignale, die einen Einfallswinkel mit der Transistorzeile bildet, und aus einer Absorptionszeile für die reflektierten Wellen (20) gebildet ist, welche mit der Transistorzelle einen Reflexionswinkel bildet, der gleich dem Einfallswinkel ist, und die mit einer resistiven absorbierenden Belastung (30) endet, die mit Masse (31) verbunden ist,

— eine Übertragungsleitung (200) für die Ausgangssignale, die vom Typ einer miniaturisierten Streifenleitung und parallel zu der Übertragungsleitung (10) für die Eingangssignale ist,

— eine erste Mehrzahl von Impedanz-Transformationsleitungen, die jeweils einerseits an die Übertragungsleitung (10) für die Eingangssignale und andererseits an eine Eingangselektrode eines Transistors angeschlossen sind, wobei jede Impedanztransformationsleitung aus zwei rechtwinkligen Metallablagerungen ($C_0$, $C_1$) gebildet ist, welche durch ein schmales Metallband ($L_1$) verbunden sind, wobei die beiden Metallablagerungen ($C_0$, $C_1$), die mit dem Substrat (1) und der Masseebene (11) Kapazitäten bilden, in Abhängigkeit von dem zu verwirklichenden Impedanztransformationsverhältnis berechnet sind, und wobei die Verbindung der Impedanztransformationsleitungen mit der Übertragungsleitung (10) für die Eingangssignale über die Metallablagerungen ($C_0$) Schlitze ($IF_1$) zwischen den Metallablagerungen ($C_0$) frei läßt,

— eine zweite Mehrzahl von Impedanztransformationsleitungen, die hinsichtlich ihrer Bestandteile ($C'_0$, $L'_1$, $C'_1$) in gleicher Weise wie die erste Mehrzahl von Leitungen verwirklicht sind, jedoch an die Ausgangselektrode eines Transistors und an die Übertragungsleitung (200) für die Ausgangssignale angeschlossen sind, mit der sie über die Metallablagerungen ($C'_0$) verbunden sind, indem Schlitze ($IF_2$) zwischen den Metallablagerungen frei bleiben,

— wobei dieser Höchstfrequenzverstärker ferner Schlitze ($F_1$, $F_2$, $F_3$) in den Eingangs- (10), Reflexions- (20) und Ausgangs- (200) Streifenleitungen entlang ihrer Längsachse aufweisen.

2. Verstärker nach Anspruch 1, dadurch gekennzeichnet, daß die Übertragungsleitungen (100, 200) vom Typ einer miniaturisierten Streifenleitung sind, deren Leiter jeweils auf einer ersten Hauptfläche der Substratscheibe (1) graviert ist, während die Masseebene (11) durch eine Metallisierung der zweiten Hauptfläche der Scheibe, die der ersten gegenüberliegt, verwirklicht ist.

3. Verstärker nach Anspruch 1, dadurch gekennzeichnet, daß die Übertragungsleitungen (100, 200) vom koplanaren Typ sind und der zentrale Leiter jeder Leitung von Metallisierungen umgeben ist, die untereinander verbunden sind, um eine einzige Masseebene (300) zu bilden, welche auf derselben Hauptfläche der Scheibe wie der zentrale Leiter graviert ist.

4. Verstärker nach Anspruch 1, dadurch gekennzeichnet, daß er Feldeffekttransistoren umfaßt, deren Source-Elektroden mit der Masseebene (11) verbunden sind, deren Gates mit der ersten Übertragungsleitung (10) verbunden sind und deren Drain-Elektroden mit der zweiten Übertragungsleitung (200) verbunden sind.

5. Verstärker nach Anspruch 1, dadurch gekennzeichnet, daß er bipolare Transistoren umfaßt, deren Emitter mit der Masseebene (11), deren Basen mit der ersten Übertragungsleitung (10) und deren Kollektoren mit der zweiten Übertragungsleitung (200) verbunden sind.

6. Verstärker nach Anspruch 3, dadurch gekennzeichnet, daß die Übertragungsleitungen (10, 200) vom koplanaren Typ und die Transistoren vom Feldeffekttyp sind, deren Source-Elektroden mit der Metallisierung der Masseebene (300) verbunden sind, wobei diese Metallisierung unter einem Teil der Impedanztransformationsleitungen verläuft, unter Zwischenfügung einer isolierenden Ablagerung zwischen der Masseebene und den letztgenannten Leitungen.

7. Verstärkervorrichtung mit wenigstens einem ersten und einem zweiten Verstärker, dadurch gekennzeichnet, daß die beiden Verstärker auf derselben Scheibe gebildet und getrennt polarisiert sind.

8. Vorrichtung nach Anspruch 9, dadurch gekennzeichnet, daß die zweite Übertragungsleitung (L51) des ersten Verstärkers und die erste Übertragungsleitung (LE2) des zweiten Verstärkers durch einen abgewinkelten Teil verbunden sind und eine kapazitive Entkopplung (401, 402) umfassen.

## Claims

1. Monolithic extremely high-frequency amplifier comprising a system for division and recombination of the power of several transistors grouped in line on a semiinsulating substrate (1), characterized in that it comprises:

— an input line (100) of microstrip type formed by a transmission line (10) for the input signals, forming an angle of incidence with the transistor line, and by an absorption line for the reflected waves (20) forming with the transistor line a reflection angle equal to the angle of incidence and terminating with a resistive absorbing load (30) which is connected to ground (31),

— a transmission line (200) for the output signals for microstrip type to the transmission line (10) for the input signals,

— a first plurality of impedance transformation lines each connected on the one hand to the transmission line (10) for the input signals and on the other hand to an input electrode of a transistor, each impedance transformation line being formed by two rectangular metallic depositions ($C_0$, $C_1$) connected by a narrow metal strip ($L_1$), the two metallic depositions ($C_0$, $C_1$) forming capacitances with the substrate (1) and the ground plane (11) being calculated as a function of the impedance transformation ratio to be realized, the connection of the impedance transformation lines to the transmission line (10) for the input signals via the metallic depositions ($C_0$) leaving free slits ($IF_1$) between the metallic depositions ($C_0$).

— a second plurality of impedance transformation lines constituted in their components ($C'_0$, $L'_1$, $C'_1$) in the same manner as the first plurality of lines but connected to the output electrode of a transistor and to the transmission line (200) for the output signals, to which they are connected via the metallic depositions ($C'_0$) leaving free slits ($IF_2$) between metallic depositions,

— this extremely high-frequency amplifier further comprises slits ($F_1$, $F_2$, $F_3$) in the input (10), reflection (20) and output (200) microstrip lines respectively along their longitudinal axes.

2. Amplifier according to claim 1, characterized in that the transmission lines (100, 200) are of the microstrip type, the conductor of each line is engraved on a first major face of the substrate wafer (1) and the ground plane (11) is obtained by a metallization of the second major face of the wafer opposite the first.

3. Amplifier according to claim 1, characterized in that the transmission lines (100, 200) are of the coplanar type, the central conductor of each line being surrounded by metallizations interconnected to form a single ground plane (300) engraved on the same major face of the wafer as the central conductor.

4. Amplifier according to claim 1, characterized in that it comprises field-effect transistors whose sources are connected to the ground plane (11), whose gates are connected to the first transmission line (10) and whose drains are connected to the second transmission line (200).

5. Amplifier according to claim 1, characterized in that it comprises bipolar transistors whose emitters are connected to the ground plane (11), whose bases are connected to the first transmission line (10) and whose collectors are connected to the second transmission line (200).

6. Amplifier according to claim 3, characterized in that the transmission lines (10, 200) are of the coplanar type and the transistors of the field-effect type, the sources being connected to the metallization of the ground plane (300), said metallization passing beneath a part of the impedance transformation lines due to the interposition of an insulating deposit between the ground plane and said latter lines.

7. Amplification device comprising at least a first and a second amplifier, characterised in that the two amplifiers are formed on the same wafer and polarized separately.

8. Device according to claim 9, characterized in that the second transmission line (L51) of the first amplifier and the first transmission line (LE2) of the second amplifier are connected by an angled portion and comprise a capacitive decoupling (401, 402).

**FIG.1**

0 047 690

**FIG. 2**

FIG.3

0 047 690

FIG. 4